(19) Europäisches Patentamt

European Patent Office

Office européen des brevets

(11) Veröffentlichungsnummer: **0 355 330**
**A2**

(12) **EUROPÄISCHE PATENTANMELDUNG**

(21) Anmeldenummer: **89111949.7**

(22) Anmeldetag: **30.06.89**

(51) Int. Cl.⁴: **H03D 13/00**

(30) Priorität: **18.08.88 DE 3828049**

(43) Veröffentlichungstag der Anmeldung:
**28.02.90 Patentblatt 90/09**

(84) Benannte Vertragsstaaten:
**BE DE ES FR GB IT NL SE**

(71) Anmelder: **ANT Nachrichtentechnik GmbH**
**Gerberstrasse 33**
**D-7150 Backnang(DE)**

(72) Erfinder: **Sperlich, Josef, Dipl.-Ing.**
**Kelterweg 52**
**D-7150 Backnang(DE)**

(54) **Verfahren und Anordnung zum Ermitteln der Phasendifferenz zwischen zwei Trägersignalen.**

(57) Ein wenig aufwendiges und mit einfachen Mitteln durchführbares Verfahren zur Detektion der Phasendifferenz zwischen zwei Trägersignalen besteht darin, daß jedes Trägersignal in eine Folge von rechteckförmigen Impulsen umgeformt wird, daß dann durch die Impulse des einen Trägersignals ein Flipflop (FF) gesetzt und durch die Impulse des anderen Trägersignals das Flipflop (FF) rückgesetzt wird und daß schließlich aus der am Ausgang (Q) des Flipflops (FF) erscheinenden Rechteckimpulsfolge ein der Breite der Rechteckimpulse proportionales Signal abgeleitet wird.

EP 0 355 330 A2

Fig. 1

## Verfahren und Anordnung zum Ermitteln der Phasendifferenz zwischen zwei Trägersignalen

Schaltungen, welche zur Ermittlung der Phasendifferenz zwischen zwei Trägersignalen dienen, werden als Phasendiskriminatoren bezeichnet. Beispielsweise werden solche Phasendiskriminatoren in Raumdiversityempfängern benötigt. Hier hat ein Phasendiskriminator die Aufgabe, festzustellen, welche Phasenablage zwischen den Trägern zweier gleicher, aber auf unterschiedlichen Wegen übertragener und von örtlich getrennten Antennen empfangener Signale besteht. Mit dieser Information über die Phasenablage kann dann die Phase einer der beiden Trägersignale so nachgeregelt werden, daß schließlich beide Signale einander phasengleich überlagert werden können.

Es ist nun die Aufgabe der Erfindung, ein wenig aufwendiges Verfahren und eine zugehörige mit einfachen Mitteln realisierbare Anordnung zum Detektieren der Phasendifferenz zwischen zwei Trägersignalen anzugeben.

Erfindungsgemäß wird diese Aufgabe durch die Merkmale der Ansprüche 1 und 4 gelöst, und zweckmäßige Ausführungen der Erfindung gehen aus den Unteransprüchen 2 und 3 hervor.

Anhand eines in der Zeichnung dargestellten Ausführungsbeispiels wird nachfolgend die Erfindung näher erläutert.

Figur 1 zeigt das Schaltbild eines Phasendiskriminators und

Figur 2 zeigt einige Signalverläufe innerhalb der Schaltung.

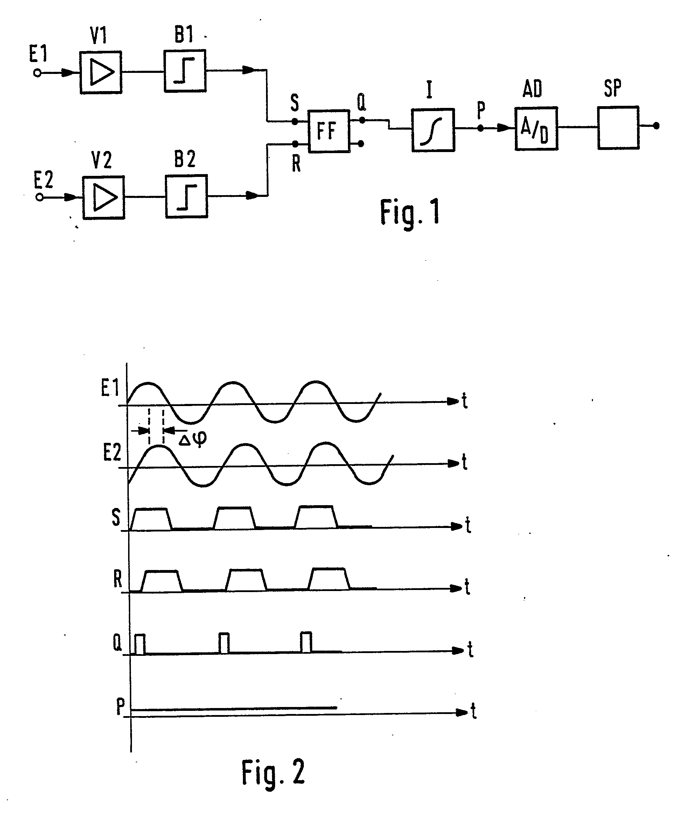

Der in Figur 1 dargestellte Phasendiskriminator weist zwei Schaltzweige auf, an deren Eingängen E1 und E2 zwei Trägersignale gleicher Frequenz anliegen. Wie der Figur 2 zu entnehmen ist, besteht zwischen dem am Eingang E1 anliegenden sinusförmigen Trägersignal und dem am Eingang E2 anliegenden gleichen Trägersignal eine Phasendifferenz $\Delta\phi$. Diese Phasendifferenz wird nun auf folgende Weise mit dem Phasendiskrimintor detektiert.

Jedes Trägersignal wird in seinem Signalzweig zunächst einem Verstärker V1 bzw. V2 mit sehr hoher Verstärkung und anschließend einem Amplitudenbegrenzer B1 bzw. B2 zugeführt. Die Begrenzungsschwellen der Amplitudenbegrenzer B1 und B2 sind so gelegt, daß die negativen Halbwellen der Trägersignale ganz unterdrückt und die hoch verstärkten positiven Halbwellen auf einen bestimmten Pegel begrenzt werden. Dadurch wird jedes Trägersignal in eine Folge von rechteckförmigen Impulsen umgewandelt. Beide Impulsfolgen an den Ausgängen der Amplitudenbegrenzer B1 und B2 (vgl. Fig. 2, S, R) sind wie die ursprünglichen Trägersignale um die Phase $\Delta\phi$ gegeneinander versetzt. Die Impulsfolge aus dem einen Amplitudenbegrenzer B1 wird nun auf den Setzeingang S und die Impulsfolge aus dem anderen Amplitudenbegrenzer B2 auf den Rücksetzeingang R eines Flipflops FF gegeben. Dies hat zur Folge, daß das Flipflop FF jeweils durch einen Impuls aus dem Amplitudenbegrenzer B1 gesetzt und danach durch einen um $\Delta\phi$ phasenverschobenen Impuls aus dem Amplitudenbegrenzer B2 wieder rückgesetzt wird.

Somit erscheint am Ausgang Q des Flipflops eine Folge von Rechteckimpulsen (s. Figur 2), deren Breite von der Phasendifferenz $\Delta\phi$ zwischen den Impulsen an den Flipflopeingängen S und R abhängt. Um aus den am Flipflopausgang Q anliegenden Rechteckimpulsen ein der Phasendifferenz $\Delta\phi$ zwischen den Trägersignalen proportionales Signal abzuleiten, werden die einzelnen Impulse in einer Schaltungseinheit I integriert. Denn das Integral über einen Impuls ist abhängig von der Impulsbreite und damit von der Phasendifferenz $\Delta\phi$. Statt der Integration kann auch eine Mittelung der Impulsleistung durchgeführt werden. Der Impulsleistungsmittelwert ist ebenso abhängig von der Impulsbreite und daher proportional zur Phasendifferenz $\Delta\phi$. Am Ausgang P des Integrators I erscheint also ein der Phasendifferenz der beiden Trägersignale proportionales Signal, das beim in der Figur 2 gezeigten Ausführungsbeispiel einen konstanten Pegel hat, weil sich die Phasendifferenz $\Delta\phi$ mit der Zeit nicht ändert.

Sofern es zweckmäßig ist, kann das analoge, der Phasendifferenz $\Delta\phi$ proportionale Signal mit Hilfe eines Analog-Digitalwandlers AD in ein digitales Signal umgesetzt werden. Die digitale Information über die Phasendifferenz $\Delta\phi$ ist dann in einem Speicher SP ablegbar.

### Ansprüche

1. Verfahren zum Ermitteln der Phasendifferenz zwischen zwei Trägersignalen, dadurch gekennzeichnet, daß jedes Trägersignal in eine Folge von rechteckförmigen Impulsen umgeformt wird, daß dann durch die Impulse des einen Trägersignals ein Flipflop (FF) gesetzt und durch die Impulse des anderen Trägersignals das Flipflop (FF) rückgesetzt wird und daß schließlich aus der am Ausgang (Q) des Flipflop (FF) erscheinenden Rechteckimpulsfolge ein der Breite der Rechteckimpulse proportionales Signal abgeleitet wird.

2. Verfahren nach Anspruch 1, dadurch gekennzeichnet, daß die Trägersignale durch eine hohe Verstärkung (V1, V2) und anschließende Amplitudenbegrenzung (B1, B2) in rechteckförmige Impulse umgeformt werden.

3. Verfahren nach Anspruch 1, dadurch gekennzeichnet, daß die am Ausgang (Q) des Flipflops (FF) erscheinende Rechteckimpulse einer Ingeration unterzogen werden.

4. Verfahren nach Anspruch 1, dadurch gekennzeichnet, daß die am Ausgang (Q) des Flipflops (FF) erscheinenden Rechteckimpulse einer Leistungsmittelung unterzogen werden.

5. Phasendiskriminator zum Durchführen des Verfahrens nach den vorhergehenden Ansprüchen, dadurch gekennzeichnet, daß für jedes Trägersignal ein Signalpfad mit Mitteln (V1, B1, V2, B2) zur Umformung der Trägersignalschwingungen in rechteckförmige Impulse vorhanden ist, daß die beiden Signalpfade an je einen Eingang (S, R) eines Flipflops (FF) angeschaltet sind und daß das Ausgangssignal des Flipflops (FF) an den Eingang einer Schaltung (I) zur Integration oder Mittelwertbildung gelegt ist.

Fig. 1

Fig. 2